# EUROPÄISCHE PATENTSCHRIFT

(11) **EP 1 422 986 B1**
(45) Veröffentlichungstag und Bekanntmachung des Hinweises auf die Patenterteilung: **22.08.2007**
(21) Anmeldenummer: 02026386.9
(22) Anmeldetag: 25.11.2002
(51) Int. Cl.: H05K 13/04

(54) **Chipübergabestation einer Bondmaschine**
Chip transfer station for a bonding machine
Station de transfert de puces dans une machine de soudage

(43) Veröffentlichungstag der Anmeldung: 26.05.2004
(73) Patentinhaber: F & K Delvotec Bondtechnik GmbH, 85521 Ottobrunn (DE)
(72) Erfinder: Farassat, Farhad, Dr.-Ing., 82024 Taufkirchen (DE)
(74) Vertreter: Popp, Eugen

(56) Entgegenhaltungen:
- EP-A- 0 772 229
- US-A- 5 839 187

## Beschreibung

Die Erfindung betrifft eine Chipübergabestation einer Bondmaschine, und zwar insbesondere einer solchen vom Typ des Flipchip-Bonders. Es handelt sich dabei um eine Einrichtung zum Übernehmen von auf einer Folie zugeführten elektronischen Schaltungen auf eine Leiterplatte, insbesondere ein Keramiksubstrat.

Bei der bekannten Flipchip-Methode werden die Schaltungen (Chips) in der Bondmaschine durch unterhalb der Folie platzierte Ausstechnadeln von der Folie abgehoben und von einer Saugnadel erfasst, um 180° geschwenkt, anschließend von einer weiteren Saugnadel erfasst und schließlich zum direkten Bonden auf zugehörige Kontaktbahnen der Leiterplatte relativ zu dieser präzise positioniert. Eine solche Einrichtung ist aus der JP 02 056944 A bekannt; vgl. auch Patent Abstracts of Japan, Vol. 014, No. 225 (E-0927) vom 14. Mai 1990. Eine weitere Einrichtung dieser Art ist bekannt aus der EP 1 057 388 B1.

Aufgabe der Erfindung ist es, eine weiter verbesserte Einrichtung dieser Art bereitzustellen, die insbesondere einerseits eine hohe Positioniergenauigkeit realisieren kann und andererseits zuverlässig und in einer die empfindlichen Chips ebenso wie die Kontaktbahnen der Leiterplatte schonenden Weise funktioniert.

Diese Aufgabe wird durch eine Chipübergabestation mit den Merkmalen des Anspruchs 1 gelöst. Zweckmäßige Fortbildungen des Erfindungsgedankens sind Gegenstand der abhängigen Ansprüche.

Die vorgeschlagene Chipübergabestation hat einen mehrachsigen Positioniermechanismus, der auf einem Grundkörper gehaltert ist, und ein durch den Positioniermechanismus positionierbares Saugnadelmodul mit der an eine Unterdruckleitung angeschlossenen (ersten) Saugnadel. Zum Positioniermechanismus gehört eine Saugnadel-Verfahreinheit, welche einen Antriebsmotor, einen mit diesem gekoppelten Riementrieb und ein über den Riementrieb angetriebenes Saugnadel-Wendegetriebe aufweist, wobei das Saugnadel-Wendegetriebe eine auf einer Schwenkachse sitzende Saugnadelhalterung und eine mit der Schwenkachse drehfest verbundene Riemenscheibe umfasst.

Die Erfindung schließt den Gedanken ein, die Saugnadelhalterung - vereinfacht dargestellt - aus einem Führungsblock und einem nur in z-Richtung verschieblichen Saugnadelschlitten aufzubauen, welcher am Führungsblock gelagert ist und die eigentliche Aufnahme für die Saugnadel bildet. Weiterhin umfasst die Erfindung den Gedanken der Betätigung des Saugnadelschlittens über eine mit der Riemenscheibe über die Schwenkachse drehfest verbundene Betätigungsgabel, zwischen deren Zinken ein am Schlitten angebrachter Zapfen oder Bolzen aufgenommen ist. Durch die Betätigungsgabel wird, gemäß einem wesentlichen Aspekt der Erfindung, der Saugnadelschlitten in +z-Richtung und -z-Richtung angetrieben und zwangsgeführt.

Während der Führungsblock selbst auf der Schwenkachse anschlagbegrenzt um exakt 180° und die Betätigungsgabel um mehr als 180° verschwenkbar ist, resultiert aus dieser Art der Betätigung und Führung des Schlittens eine zur Chipoberfläche exakt senkrecht ausgerichtete Annäherung und Berührung der Saugnadel. Hierdurch werden laterale Relativbewegungen zwischen Saugnadel und Chipoberfläche beim Ergreifen des Chips, die erhebliche Beschädigungs- und somit Ausfallrisiken mit sich bringen, zuverlässig unterbunden.

In einer bevorzugten Ausführung der Erfindung ist der Saugnadelschlitten federbelastet im Führungsblock gelagert und/oder die Saugnadel federnd am Saugnadelschlitten angebracht. Noch spezieller ist hierbei der Saugnadelschlitten als Tandemschlitten mit einem in einer z-Gleitführung des Führungsblockes verschieblichen ersten Schlittenteil und einem in einer z-Gleitführung des ersten Schlittenteils federbelastet verschieblichen zweiten Schlittenteil ausgebildet.

Durch diesen kombinierten Federeinsatz wird eine "weiche" Heranführung der Saugnadel an die Chipoberfläche realisiert und zugleich eine Beschädigung derselben durch unzulässig hohe vertikale Druckkräfte (die ja nach Ausschließung lateraler Relativbewegungen durch die oben erwähnte GabelFührung die einzige Gefahrenquelle für den Chip darstellen) vermieden.

In einer ersten sinnvollen- und aus derzeitiger Sicht bevorzugten - Ausführung der gefederten Führung des Saugnadelschlittens bzw. ersten Schlittenteils am Führungsblock ist einer Vertikalführung des Führungsblockes eine als Druckfeder zwischen Führungsblock und Schlitten wirkende Schraubenfeder zugeordnet. In einer hierzu alternativen Ausführung wird die Federvorspannung zwischen beiden Komponenten durch eine der Schwenkachse zugeordneten Spiralfeder erzeugt. Es versteht sich, dass anstelle von Stahlfedern hierfür auch Elastomer-Federelemente eingesetzt werden können.

Die gefederte Führung des zweiten Schlittenteils gegenüber dem ersten Schlittenteil in der erwähnten Tandem-Konstruktion des Saugnadelschlittens erfolgt bevorzugt über eine zwischen beiden Teilen vorgesehene Zugfeder. Diese ist wiederum insbesondere als Stahl-Schraubenfeder ausgeführt, kann aber auch durch ein Elastomerteil gebildet sein.

Zur konstruktiv einfachen Versorgung der Saugnadel mit dem erforderlichen Unterdruck ist die Schwenkachse hohl als Teil der Unterdruckleitung ausgebildet und über einen Verbindungsschlauch oder ein Verbindungsröhrchen mit einem proximalen Ende der Saugnadel verbunden.

Die oben erwähnte exakte Begrenzung der Schwenkbewegung der gesamten Saugnadelhalterung - speziell ihres Führungsschlitten-Teils - erfolgt zweckmäßigerweise durch zwei am Grundkörper der Chipübergabestation angeordnete Anschläge. Diese können erforderlichenfalls justierbar ausgeführt sein und dienen zur Sicherung der exakt rechtwinklig zur Chipoberfläche erfolgenden Annäherung der Saugnadel einerseits und zur Festlegung einer ebenso definierten Übergabeposition zur Übergabe an die zweite Saugnadel andererseits.

Vorteile und Zweckmäßigkeiten der Erfindung ergeben sich im übrigen aus der nachfolgenden Darstellung eines bevorzugten Ausführungsbeispiels anhand der Figuren. Von diesen zeigen :
- Fig. 1: eine perspektivische Darstellung einer Saugnadel-Verfahreinheit gemäß einer Ausführungsform der Erfindung (mit teilweise abgenommener Abdeckung) und
- Fig. 2 und Fig. 3: perspektivische Darstellungen eines eine Komponente der Saugnadel-Verfahreinheit bildenden Saugnadel-Wendegetriebes aus verschiedenen Blickwinkeln.

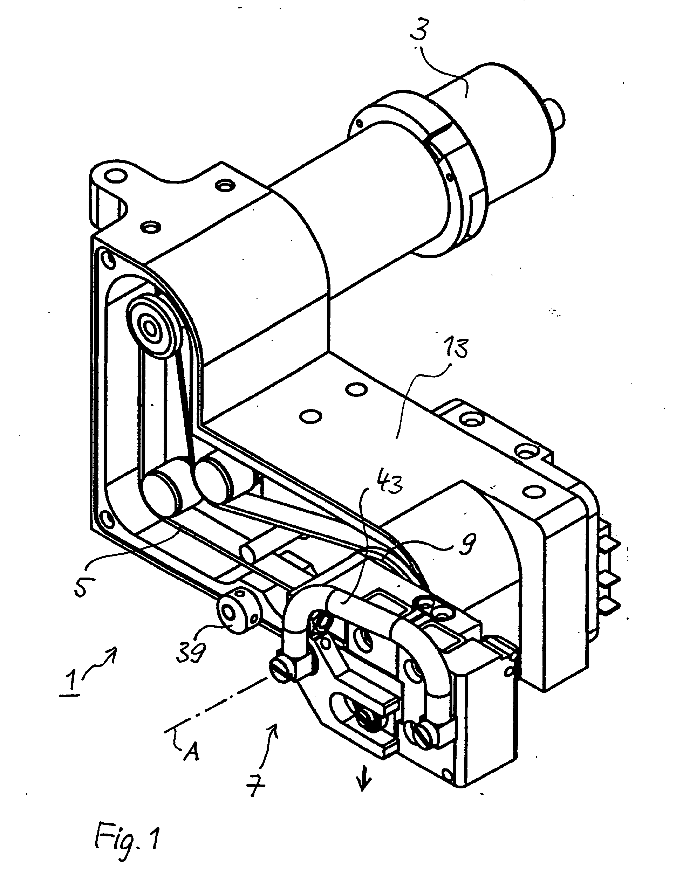

Fig. 1 zeigt eine Saugnadel-Verfahreinheit 1, die eine wesentliche Komponente einer erfindungsgemäßen Chipübergabestation als Teil eines Flipchip-Bonders bildet. Zur Saugnadel-Verfahreinheit gehört ein Antriebsmotor 3, ein mit diesem gekoppelter Riementrieb 5 und ein über diesen angetriebenes Saugnadel-Wendegetriebe 7. Dieses umfasst eine mit dem Riemen des Riementriebes im Eingriff stehende (in der Figur nahezu verdeckte) Riemenscheibe 9 und eine um eine Schwenkachse A drehbare Saugnadelhalterung 11. Die Saugnadel-Verfahreinheit 1 ist in bzw. auf einen Gehäuse 13 angeordnet; die Saugnadel selbst ist in den Figuren fortgelassen.

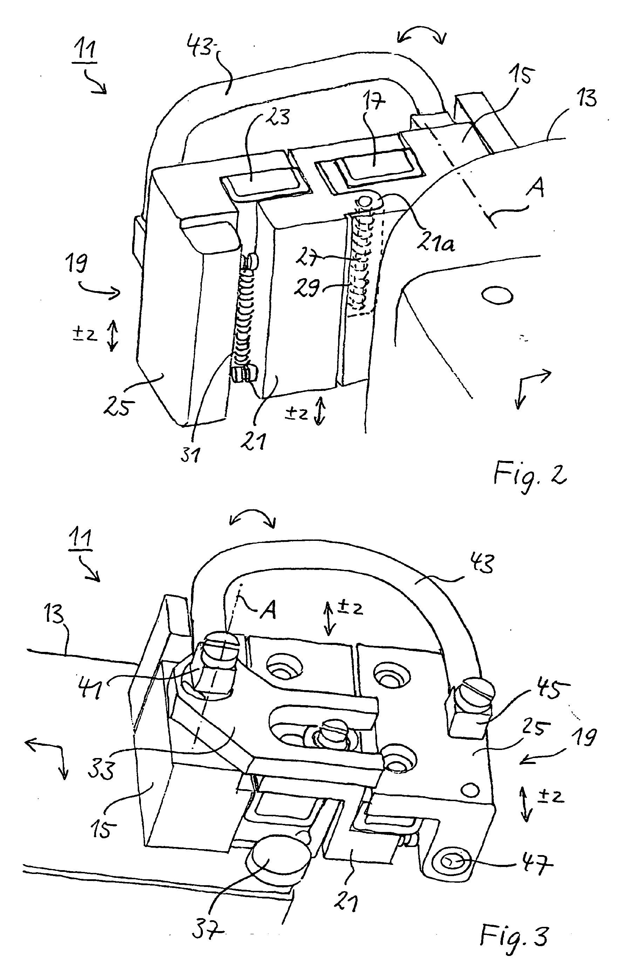

Wie in Fig. 2 und 3 dargestellt, umfasst die Saugnadelhalterung einen fest auf der Schwenkachse A sitzenden Führungsblock 15 und einem über eine erste Gleitführung 17 in z-Richtung verschieblich am Führungsblock 15 gelagerten Tandemschlitten 19. Dieser umfasst ein erstes, direkt mit der Gleitführung 17 im Eingriff stehendes Schlittenteil 21 und ein zweites, über eine zweite Gleitführung 23 in z-Richtung verschieblich am ersten Schlittenteil 21 gehaltertes Schlittenteil 25. Neben der Gleitführung 17 ist im Führungsblock 15 ein vertikaler Führungsstift 27 angeordnet, der von einer ersten Stahl-Schraubenfeder 29 umgeben ist.

Ein Fortsatz 21a an der Oberfläche des ersten Schlittenteils 21, der mit einer entsprechenden Bohrung versehen ist, umgreift den Führungsstift 27 und bildet ein (oberes) Widerlager für die Schraubenfeder 29, welche sich an ihrem unteren Ende an einem (nicht gesondert bezeichneten) Widerlager im Führungsblock 15 abstützt. Die Schraubenfeder 29 wirkt als Druckfeder und spannt in der in Fig. 2 und Fig. 3 gezeigten Betriebsstellung der Saugnadelhalterung 11 den Tandemschlitten 19 in seine oberste zulässige Stellung gegenüber dem Führungsblock 15 vor.

Benachbart zur zweiten Gleitführung 23, weisen das erste Schlittenteil 21 und das zweite Schlittenteil 25 jeweils einen (in den Figuren nicht gesondert bezeichneten) Stift oder Bolzen auf, zwischen denen eine zweite Stahl-Schraubenfeder 31 als Zugfeder verspannt ist. Diese spannt beide Teile 21, 25 in die unterste zulässige Relativposition vor, ermöglicht aber ein Ausweichen des zweiten Schlittenteils 25 nach oben, falls die daran unten angebrachte (nicht gezeigte) Saugnadel bei einer Abwärtsbewegung des Tandemschlittens 19 auf ein Hindernis (im konkreten Fall die Oberfläche eines zu übergebenden Chips) auftrifft.

In Fig. 3 ist als Element zur Umsetzung einer durch den Riementrieb 5 (Fig. 1) vermittelten Drehbewegung der Saugnadelhalterung um die Schwenkachse A in eine in -z-Richtung gerichtete Verschiebung der Saugnadel eine Betätigungsgabel 33 gezeigt, zwischen deren Zinken ein aus der Betätigungsgabel zugewandten Seitenfläche des ersten Schlittenteils 21 hervorstehender Mitnehmerbolzen 35 angeordnet ist. Eine über 180° hinausgehende Drehbewegung der Saugnadelhalterung 11 um die Schwenkachse A wird durch einen Anschlag 37 am Gehäuse 13 aufgehalten und in die erwähnte, präzise geführte Vertikalbewegung des Tandemschlittens 19 zur Annäherung an die Oberfläche eines zu übergebenen Chips umgesetzt. An dieser Stelle wird noch darauf hingewiesen, dass ein weiterer Anschlag 39 am Gehäuse 13 (Fig. 1) in analoger Weise die Schwenkbewegung der Saugnadelhalterung in die andere Schwenkrichtung begrenzt.

Zum Ergreifen des Chips wird die Saugnadel mit Unterdruck versorgt, der über einen ersten Vakuumanschluss 41 am Führungsblock 15, ein Verbindungsröhrchen 43 und einen zweiten Vakuumanschluss 45 am zweiten Schlittenteil 25 einem Saugnadelanschluss 47 an der Unterseite des zweiten Schlittenteils 25 und somit letztlich dem distalen Ende der Saugnadel zugeführt wird.

Die Ausführung der Erfindung ist nicht auf das oben beschriebene Beispiel und die in diesem Zusammenhang hervorgehobenen Aspekte beschränkt, sondern ebenso in einer Vielzahl von Abwandlungen möglich, die im Rahmen fachgemäßen Handels liegen. Insbesondere liegen verschiedenartige Kombinationen der erwähnten Aspekte der vorgeschlagenen Lösung im Rahmen der Erfindung.

### Bezugszeichenliste:

- 1: Saugnadel-Verfahreinheit
- 3: Antriebsmotoer
- 5: Riementrieb
- 7: Saugnadel-Wendegetriebe
- 9: Riemenscheibe
- 11: Saugnadelhalterung
- 13: Gehäuse
- 15: Führungsblock
- 17, 23: Gleitführung
- 19: Tandemschlitten
- 21, 25: Schlittenteil
- 21a: Fortsatz
- 27: Führungsstift
- 29: Stahl-Schraubenfeder (Druckfeder)
- 31: Stahl-Schraubenfeder (Zugfeder)
- 33: Betätigungsgabel
- 35: Mitnehmerbolzen
- 37, 39: Anschlag
- 41, 45: Vakuumanschluss
- 43: Verbindungsröhrchen
- 47: Saugnadelanschluss

- A: Schwenkachse

## Patentansprüche

1. Chipübergabestation einer Bondmaschine, insbesondere vom Typ des Flipchip-Bonders, mit
einem mehrachsigen Positioniermechanismus und
einem am Positioniermechanismus angebrachten und durch diesen positionierbaren Saugnadelmodul mit einem Gehäuse (13) einer an eine Unterdruckleitung angeschlossenen Saugnadel zum Erfassen von Chips, insbesondere vom Flipchip-Typ, und einer Saugnadel-Verfahreinheit (1), welche einen Antriebsmotor (3), einen mit diesem gekoppelten Riementrieb (5) und ein über den Riementrieb angetriebenes Saugnadel-Wendegetriebe (7) aufweist, wobei
das Saugnadel-Wendegetriebe eine auf einer Schwenkachse (A) sitzende Saugnadelhalterung (11) und eine mit der Schwenkachse drehfest verbundene Riemenscheibe (9) umfasst,
**dadurch gekennzeichnet, dass**
die Saugnadelhalterung (11) einen Führungsblock (15) zur Lagerung eines nur in z-Richtung verschieblichen Saugnadelschlittens (19) zur Aufnahme der Saugnadel mit einem parallel zur Schwenkachse ausgerichteten Zapfen oder Bolzen (35) aufweist und
mit der Riemenscheibe über die Schwenkachse drehfest eine Betätigungsgabel (33) verbunden ist, mit der der Zapfen oder Bolzen des Saugnadelschlittens im Eingriff steht und über die der Saugnadelschlitten in +z-Richtung und -z-Richtung angetrieben und zwangsgeführt wird, wobei der Führungsblock auf der Schwenkachse anschlagbegrenzt um 180° und die Betätigungsgabel um mehr als 180° verschwenkbar ist.

2. Chipübergabestation nach Anspruch 1,
**dadurch gekennzeichnet,dass**
der Saugnadelschlitten (19) federbelastet im Führungsblock (15) gelagert und/oder die Saugnadel federnd am Saugnadelschlitten angebracht ist.

3. Chipübergabestation nach Anspruch 1 oder 2,
**dadurch gekennzeichnet,dass**
der Saugnadelschlitten (19) als Tandemschlitten mit einem in einer z-Gleitführung (19) des Führungsblockes verschieblichen ersten Schlittenteil (21) und einem in einer z-Gleitführung (23) des ersten Schlittenteils federbelastet verschieblichen zweiten Schlittenteil (25) ausgebildet ist.

4. Chipübergabestation nach Anspruch 3,
**dadurch gekennzeichnet,dass**
die z-Gleitführung des ersten Schlittenteils eine als Zugfeder (31) wirkende Schraubenfeder aufweist, deren erstes Ende am ersten Schlittenteil (21) und deren zweites Ende am zweiten Schlittenteil (25) angebracht ist.

5. Chipübergabestation nach einen der vorangehenden Ansprüche,
**dadurch gekennzeichnet, dass**
der Saugnadelschlitten (19) federbelastet in der z-Gleitführung (19) des Führungsblockes (15) gelagert ist.

6. Chipübergabestation nach Anspruch 5,
**dadurch gekennzeichnet,dass**
die z-Gleitführung (19) des Führungsblockes (15) eine als Druckfeder (29) wirkende Schraubenfeder aufweist, deren erstes Ende sich an einem Widerlager des Führungsblockes abstützt und deren zweites Ende sich an einem Widerlager (21a) am Saugnadelschlitten (19) abstützt.

7. Chipübergabestation nach Anspruch 5,
**dadurch gekennzeichnet, dass**
im Führungsblock in Zuordnung zur Schwenkachse eine als Druckfeder wirkende Spiralfeder vorgesehen ist, deren erstes Ende sich gegen ein Widerlager im Führungsblock abstützt und deren zweites Ende sich gegen ein Widerlager am Saugnadelschlitten abstützt.

8. Chipübergabestation nach einem der vorangehenden Ansprüche,
**dadurch gekennzeichnet,dass**
die Schwenkachse hohl als Teil der Unterdruckleitung ausgebildet und über einen Verbindungsschlauch oder ein Verbindungsröhrchen (43) mit einem proximalen Ende der Saugnadel verbunden ist.

9. Chipübergabestation nach einem der vorangehenden Ansprüche,
**dadurch gekennzeichnet,dass**
am Gehäuse (13) ein erster und zweiter Anschlag (37, 39) zur exakten Festlegung des 180°-Schwenkbereiches der Saugnadelhalterung (11) vorgesehen sind.

10. Verwendung einer Chipübergabestation nach einem der vorangehenden Ansprüche in einer Bondmaschine, insbesondere vom Typ des Flipchip-Bonders.

## Claims

1. Chip transfer station of a bonding machine, especially of the flip chip bonder type, having
a multi-axis positioning mechanism and
a suction needle module mounted on and arranged to be positioned by the positioning mechanism, having a housing (13) of a suction needle - connected to a vacuum line - for picking up chips, especially of the flip chip type, and having a suction needle travel unit (1) comprising a drive motor (3), a belt
drive (5) coupled thereto and a suction needle turn-over mechanism (7) driven by way of the belt drive,
the suction needle turn-over mechanism comprising a suction needle
holder (11), located on a pivot shaft (A), and a belt pulley (9) connected to the pivot shaft for conjoint rotation therewith,
**characterised in that**
the suction needle holder (11) has a guide block (15) for mounting of a suction needle carriage (19), displaceable only in the z direction, for accommodation of the suction needle, having a pin or bolt (35) oriented parallel to the pivot shaft, and
an actuation fork (33) is connected by way of the pivot shaft to the belt pulley for conjoint rotation therewith, with which fork the pin or bolt of the suction needle carriage is in engagement and by means of which fork the suction needle carriage is driven and guided positively in the +z direction and -z direction,
the guide block being pivotable, with end-stop limitation, on the pivot shaft through 180° and the actuation fork being pivotable through more than 180°.

2. Chip transfer station according to claim 1,
**characterised in that**
the suction needle carriage (19) is mounted in the guide block (15) under spring loading and/or the suction needle is resiliently attached to the suction needle carriage.

3. Chip transfer station according to claim 1 or 2,
**characterised in that**
the suction needle carriage (19) is in the form of a tandem carriage having
a first carriage part (21) displaceable in a z-slideway (19) of the guide block and a second carriage part (25) displaceable under spring loading in a z-slideway (23) of the first carriage part.

4. Chip transfer station according to claim 3,
**characterised in that**
the z-slideway of the first carriage part has a helical spring acting as a tension spring (31), the first end of which is attached to the first carriage part (21) and the second end of which is attached to the second carriage part (25).

5. Chip transfer station according to one of the preceding claims,
**characterised in that**
the suction needle carriage (19) is mounted under spring loading in the z-slideway (19) of the guide block (15).

6. Chip transfer station according to claim 5,
**characterised in that**
the z-slideway (19) of the guide block (15) has a helical spring acting as a compression spring (29), the first end of which rests against an abutment of the guide block and the second end of which rests against an abutment (21 a) on the suction needle carriage (19).

7. Chip transfer station according to claim 5,
**characterised in that**
in the guide block, arranged in relation to the pivot axis, there is provided a spiral spring acting as a compression spring, the first end of which rests against an abutment in the guide block and the second end of which rests against an abutment on the suction needle carriage.

8. Chip transfer station according to one of the preceding claims,
**characterised in that**
the pivot shaft is of hollow construction as part of the vacuum line and is in communication by way of a connecting hose or a connecting tube (43) with a proximal end of the suction needle.

9. Chip transfer station according to one of the preceding claims,
**characterised in that**
on the housing (13) there are provided first and second end-stops (37, 39) for exact determination of the 180° pivot range of the suction needle holder (11).

10. Use of a chip transfer station according to one of the preceding claims in a bonding machine, especially of the flip chip bonder type.

## Revendications

1. Poste de transfert de puces d'une machine de brasure, en particulier du type de brasure de puces retournées, avec un mécanisme de positionnement à axes multiples et un module d'aiguille d'aspiration monté sur le mécanisme de positionnement et positionnable à l'aide de celui-ci avec un boîtier (13) d'une aiguille d'aspiration raccordée à une conduite de dépression pour la saisie de puces, en particulier du type puces retournées, et une unité de déplacement d'aiguille d'aspiration (1) qui comporte un moteur d'entraînement (3), une transmission à courroie (5) couplée à celui-ci et un mécanisme de renversement d'aiguille d'aspiration (7) entraîné par la transmission à courroie, le mécanisme de renversement d'aiguille d'aspiration comprenant un support d'aiguille d'aspiration (11) posé sur un axe de pivotement (A) et une poulie à courroie (9) reliée à l'axe de pivotement de manière à résister à la rotation,
**caractérisé en ce que**
le support d'aiguille d'aspiration (11) comporte un bloc de guidage (15) pour le positionnement d'un chariot d'aiguille d'aspiration (19) déplaçable uniquement dans la direction z pour la réception de l'aiguille d'aspiration avec un tenon ou boulon (35) orienté parallèlement à l'axe de pivotement, et
une chape de manoeuvre (33) est reliée à la poulie à courroie par l'intermédiaire de l'axe de pivotement de manière à résister à la rotation, chape avec laquelle le tenon ou boulon du chariot d'aiguille d'aspiration est en prise et par l'intermédiaire de laquelle le chariot d'aiguille d'aspiration est entraîné par guidage forcé dans la direction +z et dans la direction -z, le bloc de guidage pouvant pivoter de 180° sur l' axe de pivotement, limité par une butée, et la chape de manoeuvre pouvant pivoter de plus de 180°.

2. Poste de transfert de puces selon la revendication 1,
**caractérisé en ce que**
le chariot d'aiguille d'aspiration (19) est positionné commandé par ressort dans le bloc de guidage (15) et/ou l'aiguille d'aspiration est montée de manière élastique dans le chariot d'aiguille d'aspiration.

3. Poste de transfert de puces selon la revendication 1 ou 2,
**caractérisé en ce que**
le chariot d'aiguille d'aspiration (19) est conçu comme un chariot tandem avec une première partie de chariot (21) déplaçable dans un guide coulissant z (19) du bloc de guidage et une seconde partie de chariot (25) déplaçable commandée par ressort dans un guide coulissant z (23) de la première partie de chariot (21).

4. Poste de transfert de puces selon la revendication 3,
**caractérisé en ce que**
le guide coulissant z de la première partie de chariot comporte un ressort à vis fonctionnant comme ressort de traction (31) dont la première extrémité est montée sur la première partie de chariot (21) et dont la seconde extrémité est montée sur la seconde partie de chariot (25).

5. Poste de transfert de puces selon l'une quelconque des revendications précédentes,
**caractérisé en ce que**
le chariot d'aiguille d'aspiration (19) est positionné commandé par ressort dans le guide coulissant z (19) du bloc de guidage (15).

6. Poste de transfert de puces selon la revendication 5,
**caractérisé en ce que**
le guide coulissant z (19) du bloc de guidage (15) comporte un ressort à vis fonctionnant comme ressort de traction (29) dont la première extrémité s'appuie sur une butée du bloc de guidage et dont la seconde extrémité s'appuie sur une butée (21a) dans le chariot d'aiguille d'aspiration (19).

7. Poste de transfert de puces selon la revendication 5,
**caractérisé en ce**
**qu'**il est prévu dans le bloc de guidage, en correspondance avec l'axe de pivotement, un ressort à boudin fonctionnant comme ressort de traction dont la première extrémité s'appuie sur une butée dans le bloc de guidage et dont la seconde extrémité s'appuie contre une butée dans le chariot d'aiguille d'aspiration.

8. Poste de transfert de puces selon l'une quelconque des revendications précédentes,
**caractérisé en ce que**
l'axe de pivotement est conçu comme un élément de la conduite de dépression et **en ce qu'**il est raccordé à une extrémité proximale de l'aiguille d'aspiration par l'intermédiaire d'un flexible de raccordement ou d'un petit tube de raccordement (43).

9. Poste de transfert de puces selon l'une quelconque des revendications précédentes,
**caractérisé en ce**
**qu'**il est prévu dans le boîtier (13) une première et une seconde butée (37, 39) pour la localisation précise de la plage de pivotement de 180° du support d'aiguille d'aspiration (11).

10. Utilisation d'un poste de transfert de puces selon l'une quelconque des revendications précédentes dans une machine de brasure, en particulier du type de brasure de puces retournées.
